Europäisches Patentamt

European Patent Office

Office européen des brevets

(11) Publication number: **0 036 500**
**B1**

# EUROPEAN PATENT SPECIFICATION

(45) Date of publication of patent specification: **31.08.83**

(21) Application number: **81101368.9**

(22) Date of filing: **25.02.81**

(51) Int. Cl.³: **H 01 L 21/60,**
**H 01 L 21/31,**
**H 01 L 29/48, H 01 L 29/91**

(54) Method for making stable nitride-defined Schottky barrier diodes.

(30) Priority: **24.03.80 US 133069**

(43) Date of publication of application:
**30.09.81 Bulletin 81/39**

(45) Publication of the grant of the patent:
**31.08.83 Bulletin 83/35**

(84) Designated Contracting States:
**DE FR GB IT**

(73) Proprietor: **International Business Machines**
**Corporation**
**Old Orchard Road**
**Armonk, N.Y. 10504 (US)**

(72) Inventor: **Anantha, Narasipur Gundappa**
**1 Valdemar Road**
**Hopewell Junction, N.Y. 12533 (US)**
Inventor: **Bhatia, Harsaran Singh**
**41 Tor Road**
**Wappingers Falls, N.Y. 12590 (US)**

(74) Representative: **Busch, Robert, Dipl.-Ing.**
**Schönaicher Strasse 220**
**D-7030 Böblingen (DE)**

(56) References cited:
EP - A - 0 010 596
GB - A - 1 427 942

IBM TECHNICAL DISCLOSURE BULLETIN, Vol.
22, No. 11, April 1980 New York M. BRISKA et al.
"Method of Producing Schottky Contacts" page
4964

IBM TECHNICAL DISCLOSURE BULLETIN, Vol.
22, No. 8A, January 1980 New York F.H.
GAENSSLEN "Nitride-Limited Schottky Barrier
Diode Design" pages 3397 to 3398

(56) References cited:
IBM TECHNICAL DISCLOSURE BULLETIN, Vol.
21, No. 5, October 1978 New York S.U. KIM
"Stabilization of Reverse Instability of Nitride-
Defined Schottky Barrier Diode" page 1816

IBM TECHNICAL DISCLOSURE BULLETIN, Vol.
20, No. 9, February 1978 New York S.D.
MALAVIYA et al. "Schottky Barrier Diode" pages
3486 to 3487

Method for making stable nitride-defined Schottky barrier diodes

The invention relates to a method for making Schottky contacts through nitride-defined holes to underlying silicon substrates according to the first part of claim 1 in order to avoid excessive reverse leakage in Schottky diodes when Schottky contacts are made through holes in overlying layers of silicon nitride and silicon dioxide. Such a method is for instance known from the IBM Technical Disclosure Bulletin, Vol. 22, No. 8A, January 1980, pages 3397 and 3398.

It has been found that nitride-defined Schottky barrier diodes, after initial stressing in the normal forward mode of operation to a current density of about 1000 A/cm², often exhibit extensive leakage when biased in the reverse direction following the aforesaid initial stressing. Such excessive leakage normally is not encountered in other types such as oxide-defined Schottky barrier diodes. It is desirable, therefore, that a method compatible with the use of silicon-nitride be found for reducing or eliminating excessive leakage in nitride-defined Schottky barrier diodes.

The invention as claimed is intended to remedy these drawbacks. It solves the problem of reducing or eliminating the undesired leakage in nitride-defined Schottky barrier diodes by chemical vapor depositing (CVD) a second layer of oxide on the resulting structure to fill the undercut region of said first oxide layer and then reactively ion etching away all of the deposited oxide until said second layer of oxide is removed from said substrate and said substrate is exposed through a hole smaller than said first and second holes. The Schottky metal contact is deposited inside the reactively ion etched contact opening.

Owing to the Schottky metal being in direct contact with CVD oxide the advantages offered by the invention are mainly that at least half of any charges that might be trapped in the CVD oxide are terminated in the anode formed by the Schottky metal and are not effective in causing undesirable inversion in the underlying diode contact silicon.

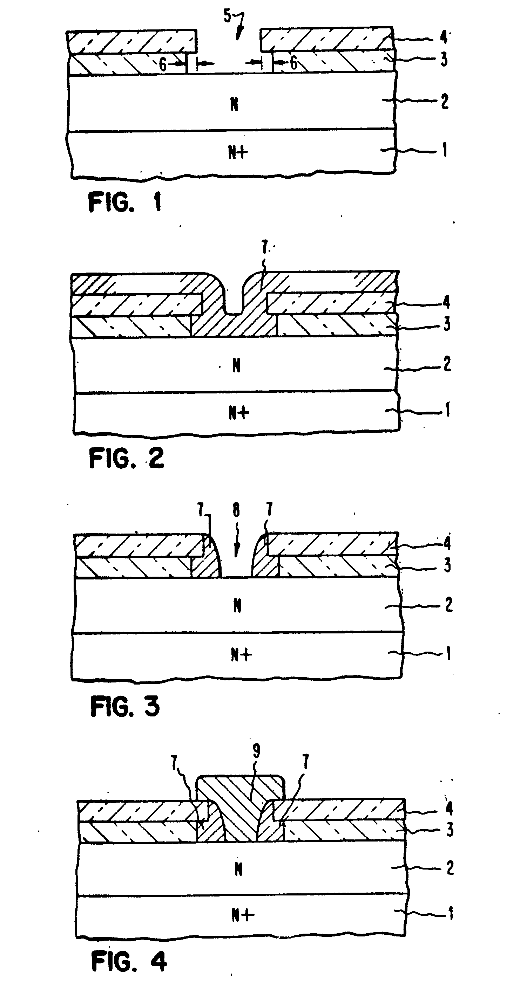

Figs. 1—4 are simplified cross-sectional views of a nitride-defined Schottky barrier diode as it appears at successive times during fabrication in accordance with the method of the present invention.

Excessive leakage experienced in nitride-defined Schottky barrier diodes has been found to be associated with the presence of a "mouse-hole" or undercut cavity in the oxide layer beneath the nitride ring defining the Schottky contact to the underlying silicon. It is believed that such leakage is caused by a native oxide which grows inside the mouse hole during chemical processing of the device and traps positive charges. The trapped charges tend to enhance the concentration of the N-type silicon of the Schottky contact below the nitride ring and increase the tunneling current component of the reverse diode current.

The "mouse-hole" structure can be better understood by reference to Fig. 1 which shows a partially completed Schottky barrier diode immediately prior to the contact metallization step of conventional practice. Additional steps, to be discussed later, are taken prior to metallization, in accordance with the method of the present invention.

Referring to Fig. 1 an N+ conductivity type substrate 1 of about $10^{18}$ impurities per $cm^3$ is provided to serve as the cathode lead for the Schottky diode to be formed later. An N epitaxial layer 2 of about $10^{16}$ impurities per $cm^3$ is deposited over substrate 1 to provide the cathode electrode of the Schottky diode.

A layer of oxide 3 of about 100 nm thickness is grown over epi layer 2. Approximately 100 nm of silicon nitride 4 is chemically vapor deposited on oxide 3. Lastly, a thin layer of about 15 nm—20 nm of silicon dioxide (not shown) is chemically vapor deposited over nitride 4 to enhance the adhesion of a photoresist layer (also not shown) which is used to photolithographically open the aperture 5 in nitride layer 4 in a manner well known to those skilled in the art. Using the apertured nitride layer 4 as an etching mask, oxide layer 3 is chemically etched in a conventional manner, inherently producing the "mouse-hole" or the undercut cavity 6 in the oxide layer 3.

It is believed that a native oxide (not shown) of uncontrolled thickness would grow in cavity 6, the oxide in turn trapping various amounts of positive charge, during subsequent cleaning operations prior to the evaporation of diode contact metallurgy in accordance with state-of-the-art practice. Charges trapped in the native oxide would tend to enhance the surface concentration of the underlying diode contact silicon surface, especially where the contact metallurgy did not completely fill in the cavity 6. Such in complete filling of the cavity 6 is the natural result where the diode contact metallurgy is deposited by evaporation. There being no metal electrode in contact with the native oxide in cavity 6, the undesired positive charges therein would terminate exclusively in the underlying diode contact silicon surface, thereby maximizing the tendency to enhance surface concentration and increasing the tunneling current component of the reverse Schottky diode current.

In accordance with the method of the present invention, however, the undercut cavity 6 is eliminated and replaced by a substantially vertically walled aperture through the nitride and oxide layers 4 and 3, respectively, before the diode contact metallurgy is evaporated. More particularly, the undercut cavity 6 is filled in with chemically vapor deposited (CVD) oxide so that aperture 5 possesses only unbroken continuous walls. Any small charges that may be trapped in the relatively clean CVD oxide will be terminated equally in the contiguous diode contact metallurgy as well as in the underlying diode contact silicon surface. Thus, the effectiveness of any unwanted oxide charge will be descreased at least by a factor of 2 in the case of the present invention as compared to a conventional structure containing the cavity 6 and non-contiguous diode contact metallurgy. The result is a decrease in the tendency to enhance the surface concentration in the underlying diode contact silicon and the realization of more stable Schottky barrier diodes.

The manner in which cavity 6 is eliminated will be described with the aid of Figs. 2 and 3. It is preferable but not mandatory that a thin layer of about 10 nm thickness of silicon-dioxide (not shown) be thermally grown over the structure of Fig. 1. Then, a layer of silicon dioxide 7 is chemically vapor deposited as shown in Fig. 2. The thickness of the deposited CVD oxide 7 is selected, relative to the amount of undercut of the cavity 6, so that the cavity is completely filled in as shown in Fig. 2. Then the structure is reactively ion etched to remove the CVD oxide from all horizontal surfaces but not from the vertical surfaces to yield the structure shown in Fig. 3. Suitable techniques for reactively ion etching the horizontal portions of a CVD oxide layer at a much higher rate than the vertical portions thereof are known from our EP-A-10596.

The series resistance of the Schottky barrier diode to be formed by the evaporation of suitable metallurgy into the reduced width aperture 8 and onto the exposed epitaxial layer 2 can be decreased, if desired, by the introduction of a reactive ion etching step to remove a thin portion of the epitaxial layer 2 exposed by the aperture 5 in the structure of Fig. 1. After the optional removal of the thin portion of epitaxial layer 2, the chemical vapor deposition of silicon dioxide layer 7 of Fig. 2 (with the optional precursor step of growing a thin layer of oxide) is carried out as previously described.

The Schottky barrier diode is completed as shown in Fig. 4 by the evaporation of suitable metallurgy 9 such as, for example, Al, TiW, PtSi, Ta and Cr, which is photolithographically defined to provide the anode terminal of the diode as is well understood. It should be noted that anode 9 is in direct contact with CVD oxide 7 so that at least half of any charges that might be trapped therein are terminated in anode 9 and are not effective in causing undesirable inversion in the underlaying diode contact silicon in the epitaxial layer 2.

## Claims

1. The method for forming hole (5) for a Schottky contact through oxide-nitride layers (3, 4) on a silicon substrate (1) comprising growing a first layer of oxide (3) on said silicon substrate (1), depositing a layer (4) of silicon nitride on said first oxide layer (3), opening up a first hole through said silicon nitride layer (4), chemically etching a contiguous second hole through said first oxide layer (3) whereby said first oxide layer (3) is undercut relative to said silicon nitride layer (4), characterized by: chemical vapor depositing a second layer of oxide (7) on the resulting structure to fill the undercut region (6) of said first oxide layer (3), and reactively ion etching said second layer of oxide (7) until said second layer of oxide (7) is removed from said substrate (1) and said substrate (1) is exposed through a hole (8) smaller than said first and second holes (5).

2. The method defined in claim 1 and further including the step of growing a layer of about 10 nm of oxide on said substrate (1) immediately prior to said chemical vapor depositing step.

3. The method defined in claim 1 and further including the step of reactively ion etching said substrate (1) immediately prior to said chemical vapor deposition step.

4. The method defined in claim 1 and further including the steps of reactively ion etching said substrate (1) and growing a layer of about 10 nm of oxide on said substrate (1) immediately prior to said chemical vapor depositing step.

5. The method defined in claim 1 and further including the step of depositing metal (9) on said substrate (1) exposed by said reactively ion etching step.

6. The method defined in claim 5 wherein said metal (9) is selected from the group comprising Al, TiW, PtSi, Ta and Cr, thus forming a Schottky barrier diode structure.

## Revendications

1. Procédé de formation d'un trou (5) pour un contact Schottky au travers de couches d'oxyde-nitrure (3, 4) sur un substrat de silicium (1) comprenant la croissance d'une première couche d'oxyde (3) sur ledit substrat de silicium (1), le dépôt d'une couche (4) de nitrure de silicium sur ladite première couche d'oxyde (3), l'ouverture d'un premier trou au travers de ladite couche de nitrure de silicium (4), le décapage chimique d'un second trou contigu au travers de ladite première couche d'oxyde (3) par lequel ladite première couche d'oxyde (3) est affouillée relativement à ladite couche de nitrure de silicium (4), caractérisé par: le dépôt chimique en phase vapeur d'une deuxième couche d'oxyde (7) sur la structure obtenue pour remplir la zone affouillée (6) de ladite première couche d'oxyde (3), et le décapage par des ions réactifs de ladite deuxième couche d'oxyde (7) jusqu'à ce que ladite deuxième couche d'oxyde (7) soit éliminée dudit substrat (1) et que ledit substrat (1) soit exposé au travers d'un trou plus petit que lesdits premier et deuxième trous (5).

2. Procédé selon la revendication 1 comprenant en outre une étape de croissance d'une couche d'approximativement 10 nm d'oxyde sur ledit substrat (1) immédiatement avant ladite étape de dépôt chimique en phase vapeur.

3. Procédé selon la revendication 1 et comprenant en outre l'exécution de l'étape de décapage par ions réactifs dudit substrat (1) immédiatement avant ladite étape de dépôt chimnique en phase vapeurs.

4. Procédé selon la revendication 1 et comprenant en outre l'exécution des étapes de décapage par ions réactifs dudit substrat (1) et de croissance d'une couche d'approximativement 10 nm d'oxyde sur ledit substrat (1) immédiatement avant ladit étape de dépôt chimique en phase vapeur.

5. Procédé selon la revendication 1 et comprenant en outre une étape de dépôt de métal (9) sur les portions dudit substrat (1) exposées par ladite étape de décapage par ions réactifs.

6. Procédé selon la revendication 5 dans lequel ledit métal (9) est sélectionné à partir du groupe comprenant les métaux suivants: Al, TiW, PtSi, Ta et Cr, formant ainsi une structure de diode à barrière de Schottky.

**Patentansprüche**

1. Verfahren zum Einbringen eines Lochs (5) für einen Schottky-Kontakt in Oxid-, Nitridschichten (3, 4) auf einem Siliciumsubstrat (1), indem eine erste Oxidschicht (3) auf besagtem Siliciumsubstrat (1) aufwachsen gelassen, eine Siliciumnitridschicht (4) auf besagte erste Oxidschicht (3) abgeschieden, ein erstes Loch durch besagte Siliciumnitridschicht (4) hindurch eingebracht und ein hieran anschließendes zweites Loch durch besagte erste Oxidschicht (3) hindurch geätzt wird, so daß besagte erste Oxidschicht (3) mit Hinblick auf besagte Siliciumnitridschicht (4) unterätzt ist, gekennzeichnet durch reaktives Abscheiden einer zweiten Oxidschicht (7) aus der Dampfphase auf das erhaltene Gebilde zwecks Ausfüllens unter-ätzten Bereichs besagter erster Oxidschicht (3) und durch solanges reaktives Ionen-Ätzen besagter zweiter Oxidschicht (7), bis besagte zweite Oxidschicht (7) vom besagten Substrat (1) abgetragen ist, so daß besagtes Substrat (1) über ein Loch (8) freigelegt wird, das kleiner als besagte erste und zweite Löcher (5) ist.

2. Verfahren, wie definiert in Anspruch 1, unter Einschluß des unmittelbar vor besagtem reaktiven Abscheiden aus der Dampfphase vor-zunehmenden Verfahrensschrittes zum Auf-wachsenlassen einer Oxidschicht von etwa 10 nm auf besagtes Substrat (1).

3. Verfahren, wie in Anspruch 1 definiert, unter Einschluß des unmittelbar vor besagtem reaktiven Abscheiden aus der Dampfphase vor-zunehmenden Verfahrensschrittes zum reak-tiven Ionen-Ätzen besagten Substrats (1).

4. Verfahren, wie in Anspruch 1 definiert, indem unmittelbar vor Anwenden besagten Verfahrensschrittes zum reaktiven Abscheiden aus der Dampfphase Verfahrensschritte zum reaktiven Ionen-Ätzen besagten Substrats (1) und zum Aufwachsenlassen einer Oxidschicht von etwa 10 nm auf besagtes Substrat vorgesehen werden.

5. Verfahren, wie in Anspruch 1 definiert, enthaltend den Verfahrensschritt zum Abscheiden von Metall (9) auf besagtes, durch be-sagten Verfahrensschritt zum reaktiven Ionen-Ätzen freigelegtes Substrat (1).

6. Verfahren, wie in Anspruch 5 definiert, bei welchem besagtes Metall (9) aus einer Gruppe, enthaltend Al, Ti-W, Pt-Si, Ta und Cr zum Aus-bilden eines Schottky-Sperrschicht-Diodenbau-elements ausgewählt wird.

FIG. 1

FIG. 2

FIG. 3

FIG. 4

1